(19)

Europäisches
Patentamt
European
Patent Office
Office européen
des brevets

(11) **EP 2 508 492 A1**

(12) **EUROPEAN PATENT APPLICATION**
published in accordance with Art. 153(4) EPC

(43) Date of publication:
**10.10.2012 Bulletin 2012/41**

(21) Application number: **10834550.5**

(22) Date of filing: **30.11.2010**

(51) Int Cl.:
*C03C 15/00* (2006.01)   *B29C 33/38* (2006.01)
*B29C 59/02* (2006.01)   *C03B 8/04* (2006.01)
*C03B 20/00* (2006.01)   *C03C 3/06* (2006.01)
*H01L 21/027* (2006.01)

(86) International application number:
**PCT/JP2010/071377**

(87) International publication number:
**WO 2011/068100 (09.06.2011 Gazette 2011/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.12.2009 JP 2009276314**

(71) Applicant: **Asahi Glass Company, Limited
Tokyo 100-8405 (JP)**

(72) Inventors:
• **KOIKE Akio
  Tokyo 100-8405 (JP)**
• **MIYASAKA Junko
  Tokyo 100-8405 (JP)**

(74) Representative: **Müller-Boré & Partner
Patentanwälte
Grafinger Straße 2
81671 München (DE)**

(54) **METHOD FOR PRODUCING SILICA-BASED GLASS SUBSTRATE FOR IMPRINT MOLD, AND METHOD FOR PRODUCING IMPRINT MOLD**

(57)     The present invention relates to a method for producing a silica glass substrate for an imprint mold, containing: obtaining a glass body from a glass-forming raw material containing an $SiO_2$ precursor; machining the glass body into a glass substrate having a predetermined shape; and removing an affected layer on a surface of the glass substrate, to produce a silica glass substrate for an imprint mold having a fictive temperature distribution in a region from the surface to a depth of 10 $\mu$m on the side to be subjected to a transfer pattern formation of the glass substrate being within $\pm30$°C.

**Description**

Technical Field

The present invention relates to a method for producing a silica-based glass substrate for an imprint mold, and a method for producing an imprint mold.

Background Art

As a method for forming a fine concave-convex pattern with a dimension of 1 nm to 10 $\mu$m on a surface of various substrates (for example, a single crystal substrate such as Si and sapphire, and an amorphous substrate such as glass) in a semiconductor device, an optical waveguide, a micro-optical element (such as diffraction grating), a biochip, a microreactor or the like, imprint lithography of pressing an imprint mold having on a surface thereof a reversed pattern (transfer pattern) of a concave-convex pattern against a curable resin layer formed on a substrate surface and curing the curable resin layer to form the concave-convex pattern on the substrate surface is attracting attention.
According to the imprint lithography, a fine concave-convex pattern can be formed on a substrate surface at a low cost compared with conventional methods.
The imprint lithography includes photo-imprint lithography of curing a photocurable resin by irradiating the resin with light (e.g., ultraviolet ray), and heat-cycle imprint lithography of curing a thermosetting resin by heating the resin.
The imprint mold for the photo-imprint lithography is required to have light transmittance, chemical resistance and dimensional stability against temperature rise due to irradiation with light.
The imprint mold for the heat-cycle imprint lithography is required to have chemical resistance, and dimensional stability during heating.
As a substrate for an imprint mold, in view of light transmittance and chemical resistance, a silica glass is often used. However, the silica glass lacks dimensional stability, because its thermal expansion coefficient near room temperature is as high as about 500 ppb/°C.
As regards a silica-based glass having a low thermal expansion coefficient, for example, the following has been proposed:

(1) silica·titania glass for a nanoimprint stamper, containing titania of from 2 mass% or more and 15 mass% or less, and a linear expansion coefficient in the temperature range of 20°C to 35°C being within the range of $\pm$ 200 ppb/°C (see, Patent Document 1).

However, there is a problem that when a transfer pattern is formed on a surface of the silica·titania glass of (1) by etching, dimensional accuracy of the transfer pattern is reduced. This problem is caused because the silica·titania glass of (1) has a variation in the titania concentration in the glass and the etching rate is increased in the portion having a high titania concentration.
In the case of forming a fine concave-convex pattern with a dimension of 1 nm to 10 $\mu$m by imprint lithography, it is required to reduce a variation in dimension of the concave-convex pattern to $\pm$10% or less, preferably $\pm$5% or less. Accordingly, the substrate for an imprint mold is required to reduce a variation in dimension of the transfer pattern formed by etching to $\pm$10% or less, preferably $\pm$5% or less.
As regards a substrate for an imprint mold, on which a transfer pattern with high dimensional accuracy can be formed, for example, the following has been proposed:

(2) a $TiO_2$-containing silica glass substrate, having a thermal expansion coefficient at 15°C to 35°C being within $\pm$200 ppb/°C, a $TiO_2$ concentration of from 4 to 9 wt%, and a $TiO_2$ concentration distribution in the surface to be subject to formation of a transfer pattern thereon being within $\pm$1 wt% (Patent Document 2).

However, in the $TiO_2$-containing silica glass substrate of (2), even when the $TiO_2$ concentration distribution in the surface is within $\pm$1 wt%, the variation in dimension of the transfer pattern sometimes exceeds $\pm$10%.
Incidentally, Patent Document 2 discloses that since the etching rate depends also on a fictive temperature distribution in the surface of the $TiO_2$-containing silica glass substrate, the fictive temperature distribution in the substrate surface is preferably controlled to be as narrow as possible (paragraphs [0022] and [0023] of Patent Document 2); and for controlling the fictive temperature distribution in the substrate surface to fall within $\pm$100°C, formed $TiO_2$-$SiO_2$ glass body is annealed under specific conditions (paragraph [0035] of Patent Document 2).
However, even when the formed $TiO_2$-$SiO_2$ glass body is annealed under the specific conditions, in the substrate for an imprint mold obtained from the glass body, a variation in etching rate on the surface occurs. Thus, the dimensional accuracy of the transfer pattern is not yet satisfied.

Related Art

Patent Document

<div align="center">

Patent Document 1:    JP-A-2006-306674

Patent Document 2:    WO2009/034954

</div>

Summary of the Invention

Problems that the Invention is to Solve

The present invention provides a method for producing a silica-based glass substrate for an imprint mold, on which a transfer pattern with high dimensional accuracy can be stably formed, and a method for producing an imprint mold having a transfer pattern with high dimensional accuracy.

Means for Solving the Problems

The present invention provides a method for producing a silica glass substrate for an imprint mold, containing: obtaining a glass body from a glass-forming raw material containing an $SiO_2$ precursor; machining the glass body into a glass substrate having a predetermined shape; and removing an affected layer on a surface of the glass substrate, to produce a silica glass substrate for an imprint mold having a fictive temperature distribution in a region from the surface to a depth of 10 $\mu$m on the side to be subjected to a transfer pattern formation of the glass substrate being within $\pm 30$°C.

In the method for producing a silica glass substrate for an imprint mold according to the present invention, it is preferred that the removal of the affected layer is performed by an etching treatment.

In the method for producing a silica glass substrate for an imprint mold according to the present invention, it is preferred that the glass substrate surface is subjected to the etching treatment to remove a region from the surface to a depth of 100 nm or more of the glass substrate.

In the method for producing a silica glass substrate for an imprint mold according to the present invention, it is preferred that the glass body is obtained by a process comprising the following steps (a) to (e):

(a) a step of depositing a glass fine particle obtained from the glass-forming raw material containing an $SiO_2$ precursor by a soot process to obtain a porous glass body,

(b) a step of heating the porous glass body to a densification temperature to obtain a dense body,

(c) a step of heating the dense body to a transparent vitrification temperature to obtain a transparent glass body,

(d) a step of, if desired, heating the transparent glass body to a softening point or higher and molding to obtain a molded glass body, and

(e) a step of annealing the transparent glass body obtained in said step (c) or the molded glass body obtained in said step (d).

The glass-forming raw material preferably further contains a $TiO_2$ precursor.

In the method for producing a silica glass substrate for an imprint mold according to the present invention, it is preferred that the etching treatment contains a process of immersion in a fluorine-containing chemical solution.

Further, the present invention provides a method for producing an imprint mold, comprising forming a transfer pattern through etching on a surface of the silica glass substrate for an imprint mold obtained by the production method of the present invention.

Advantage of the Invention

According to the method for producing a silica-based glass substrate for an imprint mold of the present invention, a silica-based glass substrate for an imprint mold, on which a transfer pattern with high dimensional accuracy can be stably formed, can be easily produced.

According to the method for producing an imprint mold of the present invention, an imprint mold having a transfer pattern with high dimensional accuracy can be easily produced.

Mode for Carrying out the Invention

<Method for Producing Silica-Based Glass Substrate for Imprint Mold>

The method for producing a silica-based glass substrate of the present invention is a method comprising: obtaining a glass body from a glass-forming raw material containing an $SiO_2$ precursor; machining the glass body into a glass substrate having a predetermined shape; and removing an affected layer on a surface of the glass substrate, to produce a silica glass substrate for an imprint mold, having a fictive temperature distribution in a region from the surface to a depth of 10 $\mu$m on the side to be subjected to a transfer pattern formation of the glass substrate is within ±30°C.

The present inventors have found that variation in etching rate on a surface of a silica glass substrate for an imprint mold, which affects dimensional accuracy of a transfer pattern, is attributable to an affected layer produced by machining such as cutting, shaving and polishing. That is, even when a glass substrate having a small fictive temperature distribution, for example, as in Patent Document 2 is prepared, if an affected layer is produced by polishing, a variation occurs in etching rate on the surface, and the dimensional accuracy of a transfer pattern is impaired. In the present invention, the affected layer indicates a region which is present in the surface produced by machining such as cutting, shaving and polishing and in which the etching rate becomes higher by 10% or more than that in the inside at a depth of 10 $\mu$m or more from the surface. The thickness of the affected layer is within several $\mu$m, usually within 1 $\mu$m, from the surface. The difference in etching rate between the surface and the inside is also produced by occurrence of a change in fictive temperature of the surface. However, the region having a different fictive temperature produced in the surface due to a heat treatment or the like is deeper than the affected layer above and gradually changed in the fictive temperature and therefore, is differentiated from the affected layer.

In the present invention, the silica-based glass means a silica ($SiO_2$) glass or a silica ($SiO_2$) glass containing $TiO_2$, $B_2O_3$, F, $SnO_2$ or the like as a dopant. In the silica-based glass, $SiO_2$ content is preferably 88 mass% or more. In the description of the present invention, the silica-based glass is sometimes simply referred to as a silica glass.

A specific example of the method for producing a silica-based glass substrate of the present invention is described in detail below by taking, as an example, the case where the silica-based glass is a $TiO_2$-$SiO_2$ glass.

The method for producing a $TiO_2$-$SiO_2$ glass substrate for an imprint mold (hereinafter, referred to as a $TiO_2$-$SiO_2$ glass substrate) includes a method containing the following steps (a) to (g):

(a) a step of depositing a $TiO_2$-$SiO_2$ glass fine particle obtained from a glass-forming raw material containing an $SiO_2$ precursor and a $TiO_2$ precursor by a soot process to obtain a porous $TiO_2$-$SiO_2$ glass body,

(b) a step of heating the porous $TiO_2$-$SiO_2$ glass body to the densification temperature to obtain a $TiO_2$-$SiO_2$ dense body,

(c) a step of heating the $TiO_2$-$SiO_2$ dense body to the transparent vitrification temperature to obtain a transparent $TiO_2$-$SiO_2$ glass body,

(d) a step of, if desired, heating the transparent $TiO_2$-$SiO_2$ glass body to a softening point or higher and molding to obtain a molded $TiO_2$-$SiO_2$ glass body,

(e) a step of annealing the transparent $TiO_2$-$SiO_2$ glass body obtained in the step (c) or the molded $TiO_2$-$SiO_2$ glass body obtained in the step (d),

(f) a step of subjecting the annealed $TiO_2$-$SiO_2$ glass body obtained in the step (e) to machining such as cutting, shaving and polishing to obtain a $TiO_2$-$SiO_2$ glass substrate having a predetermined shape, and

(g) a step of removing the affected layer on the surface of the $TiO_2$-$SiO_2$ glass substrate having a predetermined shape obtained in the step (f) to obtain a $TiO_2$-$SiO_2$ glass substrate.

(Step (a))

A $TiO_2$-$SiO_2$ glass fine particle (soot) obtained by flame hydrolysis or thermal decomposition of a $SiO_2$ precursor and a $TiO_2$ precursor each serving as a glass-forming raw material is deposited and grown on a substrate for deposition by a soot process, whereby a porous $TiO_2$-$SiO_2$ glass body is formed.

Examples of the soot process include an MCVD (Modified Chemical Vapor Deposition) process, an OVD (Outside Vapor Deposition) process and a VAD (Vapor Axial Deposition) process. The VAD process is preferred from the standpoint that, for example, the mass productivity is excellent and a glass body having a uniform composition in a large-area plane can be obtained by adjusting the production conditions such as size of the deposition substrate.

The glass-forming raw material includes a gasifiable raw material.

The $SiO_2$ precursor includes a silicon halide compound and an alkoxysilane.

The $TiO_2$ precursor includes a titanium halide compound and an alkoxytitanium.

The silicon halide compound includes a chloride (e.g., $SiCl_4$, $SiHCl_3$, $SiH_2Cl_2$, $SiH_3Cl$), a fluoride (e.g., $SiF_4$, $SiHF_3$, $SiH_2F_2$), a bromide (e.g., $SiBr_4$, $SiHBr_3$), and an iodide (e.g., $SiI_4$).

The alkoxysilane includes a compound represented by the following formula (1):

$$R_nSi(OR)_{4-n} \qquad (1)$$

wherein R is an alkyl group having a carbon number of 1 to 4, n is an integer of 0 to 3, and when a plurality of Rs are present, a part of Rs may be different.

Examples of the titanium halide compound include $TiCl_4$ and $TiBr_4$.

The alkoxytitanium includes a compound represented by the following formula (2):

$$R_nTi(OR)_{4-n} \qquad (2)$$

wherein R is an alkyl group having a carbon number of 1 to 4, n is an integer of 0 to 3, and when a plurality of Rs are present, a part of Rs may be different.

As the $SiO_2$ precursor and the $TiO_2$ precursor, a compound containing Si and Ti, such as silicon titanium double alkoxide, may be used.

The substrate for deposition includes a silica glass-made seed rod (for example, the seed rod described in JP-B-63-24937). The shape is not limited to a rod form, and a plate-shaped substrate for deposition may be also used.

(Step (b))

The porous $TiO_2$-$SiO_2$ glass body obtained in the step (a) is heated to the densification temperature in an inert gas atmosphere or a reduced pressure atmosphere to obtain a $TiO_2$-$SiO_2$ dense body.

The densification temperature means a temperature at which a porous glass body can be densified to such an extent that a void cannot be observed by an optical microscope.

The densification temperature is preferably from 1,250 to 1,550°C, and more preferably from 1,350 to 1,450°C.

The inert gas is preferably helium.

The pressure in the atmosphere is preferably from 10,000 to 200,000 Pa. In the present description, Pa means not a gauge pressure but an absolute pressure. In the case of reduced pressure, the pressure is preferably 13,000 Pa or lower.

In the step (b), it is preferred that the porous $TiO_2$-$SiO_2$ glass body is placed under reduced pressure (preferably 13,000 Pa or lower, and more preferably 1,300 Pa or lower) and then, an inert gas is introduced to create an inert gas atmosphere of a predetermined pressure, because homogeneity of the $TiO_2$-$SiO_2$ dense body is increased.

Also, in the step (b), it is preferred that the porous $TiO_2$-$SiO_2$ glass body is held in an inert gas atmosphere at room temperature or a temperature lower than the densification temperature and then, the temperature is raised to the densification temperature, because homogeneity of the $TiO_2$-$SiO_2$ dense body is increased. In this case, the holding time is preferably 2 hours or more.

In the case of incorporating F, for example, the following step may be provided before the step (b).

(Step (b'))

The porous $TiO_2$-$SiO_2$ glass body obtained in the step (a) is held in a reaction vessel where elemental fluorine ($F_2$) or a mixed gas obtained by diluting elemental fluorine ($F_2$) with an inert gas is filled and a solid metal fluoride is present, whereby a fluorine-containing porous glass body is obtained. The solid metal fluoride used is not particularly limited but is preferably a solid metal fluoride selected from the group consisting of fluoride of an alkali metal, fluoride of an alkaline earth metal and a mixture thereof, and more preferably sodium fluoride. The shape of the solid metal fluoride is not particularly limited, and an arbitrary shape suitable for arrangement in the reaction vessel may be selected. Alternatively, the porous $TiO_2$-$SiO_2$ glass body obtained in the step (a) is held at a temperature at the densification temperature or lower in a fluorine-containing gas atmosphere, whereby a fluorine-containing porous $TiO_2$-$SiO_2$ glass body is obtained. The fluorine-containing gas atmosphere is preferably an inert gas atmosphere containing from 0.1 to 100 vol% of a fluorine-containing gas (e.g., $SiF_4$, $SF_6$, $CHF_3$, $CF_4$, $C_2F_6$, $C_3F_8$). It is preferred to perform the treatment in such an atmosphere under a pressure of 10,000 to 200,000 Pa for from several tens of minutes to several hours at the above-described high temperature of the densification temperature or lower.

(Step (c))

The $TiO_2$-$SiO_2$ dense body obtained in the step (b) is heated to the transparent vitrification temperature to obtain a transparent $TiO_2$-$SiO_2$ glass body.

The transparent vitrification temperature means a temperature at which a crystal cannot be observed by an optical microscope and a transparent glass is obtained.

The transparent vitrification temperature is preferably from 1,350 to 1,750°C, and more preferably from 1,400 to 1,700°C. The atmosphere is preferably an atmosphere of 100% inert gas (e.g., helium, argon), or an atmosphere containing the inert gas (e.g., helium, argon) as a main component.

The pressure of the atmosphere is preferably reduced pressure or normal pressure. In the case of reduced pressure, the pressure is preferably 13,000 Pa or lower.

(Step (d))

The transparent $TiO_2$-$SiO_2$ glass body obtained in the step (c) is put in a mold and heated to a temperature of the softening point or higher, thereby molded into a desired shape to obtain a molded $TiO_2$-$SiO_2$ glass body.

The molding temperature is preferably from 1,500 to 1,800°C. When the molding temperature is 1,500°C or higher, the transparent $TiO_2$-$SiO_2$ glass body is reduced in the viscosity and easily deformed due to its own weight. Also, growth of cristobalite that is a crystal phase of $SiO_2$, or growth of rutile or anatase that are a crystal phase of $TiO_2$, is suppressed, and so-called devitrification hardly occurs. When the molding temperature is 1,800°C or lower, sublimation of $SiO_2$ is suppressed.

As for the inert gas, an atmosphere of 100% inert gas (e.g., helium, argon), or an atmosphere containing the inert gas (e.g., helium, argon) as a main component is preferred.

The pressure of the atmosphere is preferably from 10,000 to 200,000 Pa.

The step (d) may be repeated a plurality of times. For example, two-stage molding may be performed such that after the transparent $TiO_2$-$SiO_2$ glass body is put in a mold and heated to a temperature of the softening point or higher, the molded $TiO_2$-$SiO_2$ glass body obtained is put in another mold and again heated to a temperature of the softening point or higher.

Also, the step (c) and the step (d) may be performed sequentially or simultaneously.

In the case where the transparent $TiO_2$-$SiO_2$ glass body obtained in the step (c) is sufficiently large, a molded $TiO_2$-$SiO_2$ glass body may be obtained by cutting the transparent $TiO_2$-$SiO_2$ glass body obtained in the step (c) into a predetermined shape without performing the subsequent step (d).

The following step (d') may be performed before the step (e).

(Step (d'))

This is a step of heating the transparent $TiO_2$-$SiO_2$ glass body obtained in the step (c) or the molded $TiO_2$-$SiO_2$ glass body obtained in the step (d) at a temperature of $T_1$+400°C or higher for 20 hours or more.

$T_1$ is the annealing point (°C) of the $TiO_2$-$SiO_2$ glass body obtained in the step (e). The annealing point means a temperature at which the viscosity $\eta$ of a glass becomes $10^{13}$ dPa·s. The annealing point is determined as follows.

The viscosity of a glass is measured by a beam bending method in accordance with JIS R 3103-2:2001, and the temperature at which the viscosity $\eta$ becomes $10^{13}$ dPa·s is defined as the annealing point.

By performing the step (d'), striae in the $TiO_2$-$SiO_2$ glass body are reduced.

The "striae" indicates a compositional non-uniformity (composition distribution) in the $TiO_2$-$SiO_2$ glass body. In the $TiO_2$-$SiO_2$ glass body having striae, sites differing in the $TiO_2$ concentration are present. A site with a high $TiO_2$ concentration has a negative coefficient of thermal expansion (CTE) and therefore, the site with a high $TiO_2$ concentration tends to expand during cooling process in the step (e). At this time, when a site with a low $TiO_2$ concentration is present adjacent to the site with a high $TiO_2$ concentration, expansion of the site with a high $TiO_2$ concentration is inhibited, and a compression stress is added. As a result, a stress distribution is generated in the $TiO_2$-$SiO_2$ glass body. Hereinafter, in the present description, such a stress distribution is referred to as a "stress distribution caused by striae".

When a stress distribution caused by striae is present in a $TiO_2$-$SiO_2$ glass body used as a substrate for an imprint mold, a difference is produced in processing rate at the time of finish-processing the surface, and this affects smoothness of the surface after the finish processing.

By performing the step (d'), the stress distribution due to striae in the $TiO_2$-$SiO_2$ glass body produced through the subsequent step (e) is reduced to a level bringing about no problem in use as a substrate for an imprint mold.

The heating temperature in the step (d') is preferably lower than $T_1$+600°C, more preferably lower than $T_1$+550°C, and still more preferably lower than $T_1$+500°C, from the standpoint that foaming or sublimation in the $TiO_2$-$SiO_2$ glass body is suppressed. That is, the heating temperature in the step (d') is preferably from $T_1$+400°C to lower than $T_1$+600°C, more preferably from $T_1$+400°C to lower than $T_1$+550°C, and still more preferably from $T_1$+450°C to lower than $T_1$+500°C.

From the standpoint of, for example, balancing the effect of reducing striae and the yield of $TiO_2$-$SiO_2$ glass body and reducing the cost, the heating time in the step (d') is preferably 240 hours or less, and more preferably 150 hours or less. Also, in view of the effect of reducing striae, the heating time is preferably over 24 hours, more preferably over 48 hours, and still more preferably over 96 hours.

The step (d') and the later-described step (e) may be performed sequentially or simultaneously. Also, the step (c) and/or the step (d), and the step (d') may be performed sequentially or simultaneously. Furthermore, the step (c) or step (d), and the step (e) may be performed sequentially or simultaneously.

(Step (e))

The transparent $TiO_2$-$SiO_2$ glass body obtained in the step (c), the molded $TiO_2$-$SiO_2$ glass body obtained in the step (d), or the glass body obtained in the step (d') is subjected to an annealing treatment of heating to a temperature of 1,100°C or higher and then, cooling to a temperature of 700°C or lower at an average cooling rate of 100°C/hr or lower, whereby the fictive temperature of the $TiO_2$-$SiO_2$ glass body is controlled.

In the case of performing the step (c) or step (d) and the step (e) sequentially or simultaneously, during the cooling process of from the temperature of 1,100°C or higher in the step (c) or step (d), an annealing treatment of cooling the obtained transparent $TiO_2$-$SiO_2$ glass body or molded $TiO_2$-$SiO_2$ glass body from 1,100°C to 700°C at an average cooling rate of 100°C/hr or lower is performed, whereby the fictive temperature of the $TiO_2$-$SiO_2$ glass body is controlled.

The average cooling rate is preferably 10°C/hr or lower, more preferably 5°C/hr or lower, and still more preferably 2.5°C/hr or lower.

After cooling to a temperature of 700°C or lower, the glass body can be allowed to stand to be cooled. The atmosphere is not particularly limited.

In order to eliminate inclusions such as foreign matters and bubbles from the $TiO_2$-$SiO_2$ glass body obtained in the step (e), it is crucial to inhibit contamination in the steps (a) to (d) (particularly, in the step (a)) and furthermore, precisely control the temperature condition in the steps (b) to (d).

The above-described steps (a) to (e) are an example showing the production method of a $TiO_2$-$SiO_2$ glass body when a soot process is employed in the step (a). In the case of employing a direct process in the step (a), a transparent $TiO_2$-$SiO_2$ glass body can be obtained directly without performing the step (b) and the step (c). The direct process is a process of obtaining a transparent $TiO_2$-$SiO_2$ glass body directly by hydrolyzing/oxidizing an $SiO_2$ precursor and a $TiO_2$ precursor each serving as a glass-forming raw material, in oxyhydrogen flame at 1,800 to 2,000°C. Subsequently to the step (a) by the direct process, the step (d) and the sep (e) may be sequentially performed. Also, the transparent $TiO_2$-$SiO_2$ glass body obtained by the direct process in the step (a) may be cut into a predetermined dimension to obtain a molded $TiO_2$-$SiO_2$ glass body, and thereafter, the step (e) may be performed. The transparent $TiO_2$-$SiO_2$ glass body obtained by the direct process in the step (a) contains $H_2$ or OH. By adjusting the flame temperature or gas concentration in the direct process, the OH concentration in the transparent $TiO_2$-$SiO_2$ glass body can be controlled. The OH concentration in the transparent $TiO_2$-$SiO_2$ glass body can be also controlled by a method of holding the transparent $TiO_2$-$SiO_2$ glass body obtained by the direct process in the step (a), in a vacuum, in a reduced pressure atmosphere, or in the case of normal pressure, in an atmosphere having an $H_2$ concentration of 1,000 ppm by volume or less and an $O_2$ concentration of 18 vol% or less, at a temperature of 700 to 1,800°C for 10 minutes to 90 days, thereby achieving degassing.

(Step (f))

The $TiO_2$-$SiO_2$ glass body obtained in the step (e) is subjected to machining such as cutting, shaving and polishing, whereby a $TiO_2$-$SiO_2$ glass substrate having a predetermined shape is obtained. In the step (f), at least polishing is preferably performed.

The polishing step is preferably performed in parts in two or more steps depending on the finished condition of the polished surface. Also, in two or more polishing steps, it is preferred to properly use at least two or more kinds of polishing pads of a polyurethane foam-based pad, a nonwoven fabric-based pad and a suede-based pad. In the final polishing step, a polishing slurry using colloidal silica is preferably used.

(Step (g))

The affected layer on the surface of the $TiO_2$-$SiO_2$ glass substrate obtained in the step (f) is removed, whereby a $TiO_2$-$SiO_2$ glass substrate is obtained.

Usually, an affected layer is present on the surface of a glass substrate finished by machining such as polishing. In the case of forming a transfer pattern through etching on the surface of the glass substrate having on the surface thereof such an affected layer, a variation is liable to occur in etching rate. That is, the etching rate is high in the affected layer and even when the fictive temperature distribution of the glass body is made uniform by a heat treatment, a variation in etching rate due to the affected layer produced by machining liable to occur at the time of forming a transfer pattern. For preventing this problem, it is effective to remove the surface by a method except for machining such as polishing. In the present invention, removal of the affected layer by an etching treatment is particularly effective. Among the methods for removing the surface, from the standpoint of maintaining smoothness of the surface, a method by a chemical etching treatment using a chemical solution is preferred, a method by immersion in a fluorine-containing chemical solution is more preferred, and a method by immersion in a chemical solution containing a hydrofluoric acid is still more preferred.

In the step (g), the region from the surface to a depth of 100 nm or more on the side to be subjected to a transfer pattern formation of the $TiO_2$-$SiO_2$ glass substrate is preferably removed. When the removal amount by the etching treatment is 100 nm or more, the effect of the etching treatment is sufficiently exerted. The removal amount by the etching treatment is more preferably 200 nm or more and still more preferably 500 nm or more, from the surface. Also, the removal amount by the etching treatment is preferably less than 10 $\mu$m, more preferably less than 3 $\mu$m, still more preferably less than 2 $\mu$m, and particularly preferably less than 1 $\mu$m, from the surface. When the removal amount by the etching treatment is less than 10 $\mu$m, reduction in smoothness of the surface can be suppressed.

In the case where smoothness of the surface is reduced, mechanical polishing using a polishing slurry at a low surface pressure (from 1 to 60 gf/cm$^2$), which is called touch polishing, may be performed after the etching treatment. In the touch polishing, the glass substrate is set by sandwiching it between polishing plates each provided with a polishing pad made of nonwoven fabric, abrasive cloth or the like, and the polishing plates are relatively rotated against the glass substrate while feeding a slurry adjusted to predetermined properties, whereby the processing surface is polished at a surface pressure of 1 to 60 gf/cm$^2$. However, an affected layer is also produced by touch polishing and therefore, an etching treatment is preferably again performed after the touch polishing.

(Stress)

The standard deviation (dev[$\sigma$]) of stress caused by striae of the silica-based glass substrate obtained in the step (g) is preferably 0.05 MPa or lower, more preferably 0.04 MPa or lower, and still more preferably 0.03 MPa or lower. The glass body produced by a soot process is usually striae-free in three directions, and striae are not observed therein. However, even a glass body produced by a soot process, in the case of containing a dopant, there is a possibility that striae may be observed. If striae are present, a smooth surface is hardly obtained. Also, for the same reason, the difference ($\Delta\sigma$) between the maximum value and the minimum vale of the stress caused by striae of the silica-based glass substrate obtained in the step (g) is preferably 0.25 MPa or less, more preferably 0.2 MPa or less, and still more preferably 0.15 MPa or less.

The stress is determined by the following method.

First, a region of approximately 1 mm x 1 mm is measured by using a birefringent microscope to determine a retardation of the sample, and the stress profile is determined according to the following formula (3):

$$\Delta = C \times F \times n \times d \qquad (3)$$

wherein $\Delta$ is the retardation, C is photoelastic constant, F is stress, n is refractive index, and d is the sample thickness. From the stress profile, the standard deviation (dev[$\sigma$]), and the difference ($\Delta\sigma$) between the maximum value and the minimum value of the stress are determined.

Specifically, a sample is cut out by slicing from a silica-based glass substrate and then polished to obtain a plate-shaped sample of 30 mm x 30 mm x 0.5 mm. Using a birefringent microscope, helium neon laser light is vertically applied onto the plane of 30 mm x 30 mm of the sample, and the in-plane retardation distribution is examined at an enlarging magnification high enough to enable adequate observation of striae and converted into a stress distribution. In the case where the pitch of striae is fine, the thickness of the sample must be made thinner.

(Function and Effect)

In the method for producing a silica-based glass substrate of the present invention described above, the affected layer on the surface of the glass substrate is removed, so that a silica-based glass substrate for an imprint mold, where the fictive temperature distribution in the region from the surface to a depth of 10 $\mu$m on the side to be subjected to a transfer pattern formation is within $\pm$30°C, can be obtained. For the following reason, in this silica-based glass substrate, a transfer pattern with high dimensional accuracy can be stably formed.

That is, the present inventors have found that the increase in dimensional variation at the time of forming a transfer pattern through etching on a surface of a conventional silica-based glass substrate is caused by an affected layer produced by machining such as polishing. The etching rate in the affected layer is high as compared with that in other portions, as a result, variation arises in etching rate at the time of forming a transfer pattern through etching and also arises in dimension (particularly, the dimension in the height direction) of the transfer pattern formed by etching, and therefore, dimensional accuracy of the transfer pattern is reduced.

The affected layer has a high density and in the case of a silica-based glass substrate, this layer cannot be distinguished from a portion having a high fictive temperature.

Accordingly, in the silica-based glass substrate from which the affected layer has been removed, and which is obtained by the production method of the present invention, the fictive temperature distribution in the surface on the side to be subjected to a transfer pattern formation as well as in the region near the surface is very small. On this account, in the silica-based glass substrate obtained by the production method of the present invention, occurrence of variation in etching rate can be suppressed at the time of forming a transfer pattern through etching, and a transfer pattern with high dimensional accuracy, for example, a transfer pattern having a dimensional variation (particularly, a dimensional variation in the height direction) of preferably ±10% or less and more preferably ±5% or less, can be formed. For this reason, it is suitable as a substrate for an imprint mold, particularly a substrate for a photo-imprint mold.

Also, in the case where the silica-based glass substrate obtained by the production method of the present invention is composed of a $TiO_2$-$SiO_2$ glass, the thermal expansion coefficient in the temperature range capable of being experienced by an imprint mold during imprint lithography (in the case of photo-imprint lithography, near room temperature (however, the temperature of the mold substrate may arise by ultraviolet irradiation); and in the case of heat-cycle imprint lithography, in a temperature range from near room temperature to the curing temperature of a thermosetting resin) is small. For this reason, the silica-based glass substrate obtained by the production method of the present invention, when composed of a $TiO_2$-$SiO_2$ glass, is excellent in the dimensional stability against a temperature change capable of being experienced by an imprint mold during imprint lithography, and therefore is suitable as a substrate for an imprint mold.

(Fictive Temperature Distribution)

In the silica-based glass substrate obtained by the production method of the present invention, the fictive temperature distribution in the region from the surface to a depth of 10 $\mu$m on the side to be subjected to a transfer pattern formation is within ±30°C, and the fictive temperature distribution is preferably within ±20°C, and the fictive temperature distribution is more preferably within ±10°C. When the fictive temperature distribution is within ±30°C, the variation in etching rate at the time of forming a transfer pattern through etching on the surface of the silica-based glass substrate can be reduced.

The fictive temperature is determined by the following method.

(i) A sample whose fictive temperature is unknown is prepared. This sample is a mirror-polished glass body or a silica-based glass substrate obtained by etching the surface of the glass body above.

(ii) A plurality of kinds of glass bodies differing in the fictive temperature, each of which is a glass body having a known fictive temperature and having the same composition as the sample above, are prepared. The surfaces of the glass bodies are previously mirror-polished.

(iii) The infrared reflection spectrum on the surface of each of the glass bodies of (ii) is obtained by using an infrared spectrometer (Magna 760, manufactured by Nikolet Company). The reflection spectrum is the average value obtained by scanning 256 times. In the obtained infrared reflection spectrum, a peak observed in the vicinity of about 1,120 cm$^{-1}$ is a peak attributed to stretching vibration by an Si-O-Si bond of the glass, and the peak position depends on the fictive temperature. A calibration curve showing the relationship between the peak position and the fictive temperature, obtained with the plurality of kinds of glass bodies differing in the fictive temperature, is prepared.

(iv) An infrared reflection spectrum of the sample of (i) is obtained under the same conditions as in (iii). In the obtained infrared reflection spectrum, the position of a peak observed in the vicinity of about 1,120 cm$^{-1}$, which is attributed to stretching vibration by an Si-O-Si bond, is exactly determined. The fictive temperature is determined by comparing this peak position with the calibration curve.

Also, the fictive temperature distribution in the region from the surface to a depth of 10 $\mu$m is determined as follows.

First, the fictive temperature of the surface is determined by the method above. Subsequently, the glass body is immersed in a 10 mass% hydrofluoric acid solution for 30 seconds to 1 minute, and the mass decrease between before and after immersion is determined. From the mass decrease, the etched depth is determined according to the following formula (4):

$$\text{(Etched depth)} = \text{(mass decrease)}/((\text{density})\times(\text{surface area})) \qquad (4)$$

The fictive temperature of the surface exposed after the etching is also determined by the method above and is taken as the fictive temperature at that depth. Thereafter, the glass body is again immersed in a 10 mass% hydrofluoric solution for 30 seconds to 1 minute, and the depth and the fictive temperature are determined. By repeating this operation, the maximum value and the minimum value out of the fictive temperature values obtained by operations immediately before the depth exceeds 10 $\mu$m are determined, and the difference therebetween is taken as the fictive temperature distribution in the region from the surface to a depth of 10 $\mu$m.

(TiO$_2$-SiO$_2$ Glass)

The silica-based glass is preferably a TiO$_2$-containing silica glass (hereinafter, referred to as TiO$_2$-SiO$_2$ glass) containing TiO$_2$ as a dopant, because a silica-based glass having a low thermal expansion coefficient and excellent dimensional stability can be obtained.

The TiO$_2$ concentration in the TiO$_2$-SiO$_2$ glass (100 mass%) is preferably from 3 to 12 mass%. The silica-based glass substrate obtained by the production method of the present invention is used as a substrate for an imprint mold and therefore, is required to have dimensional stability against a temperature change. When the TiO$_2$ concentration is from 3 to 12 mass%, the thermal expansion coefficient at near room temperature can be made small. In order to make the thermal expansion coefficient at near room temperature almost zero, the TiO$_2$ concentration is more preferably from 5 to 9 mass% and still more preferably from 6 to 8 mass%.

The TiO$_2$ concentration is measured by using a fundamental parameter (FP) method in the fluorescence X-ray analysis.

The Ti$^{3+}$ concentration in the TiO$_2$-SiO$_2$ glass (100 mass%) is preferably, on average, 100 ppm by mass or less, more preferably 70 ppm by mass or less, still more preferably 20 ppm by mass or less, and particularly preferably 10 ppm by mass or less. The present inventors have found that the Ti$^{3+}$ concentration affects the coloration of TiO$_2$-SiO$_2$ glass, particularly, the internal transmittance $T_{300-700}$ per 1 mm of thickness in the wavelength region of 300 to 700 nm. When the Ti$^{3+}$ concentration is 100 ppm by mass or less, brown coloration can be suppressed, and as a result, reduction in the internal transmittance $T_{300-700}$ can be suppressed, leading to good transparency.

The Ti$^{3+}$ concentration is determined by the electron spin resonance (ESR) measurement. The measurement conditions are as follows.

Frequency: in the vicinity of 9.44 GHz (X-band),
Output: 4 mW,
Modulated magnetic field: 100 KHz, 0.2 mT,
Measurement temperature: room temperature,
ESR Species integration range: 332 to 368 mT, and
Sensitivity calibration: conducted at the peak height of Mn$^{2+}$/MgO in a given amount.

In the ESR signal (differential form) where the signal intensity is taken on the vertical axis and the magnetic field intensity (mT) is taken on the horizontal axis, a TiO$_2$-SiO$_2$ glass shows a profile having an anisotropy of $g_1$=1.988, $g_2$=1.946 and $g_3$=1.915. Usually, Ti$^{3+}$ in glass is observed around g=1.9 and therefore, those signals are designated as signals derived from Ti$^{3+}$. The Ti$^{3+}$ concentration is obtained by comparing the intensity after double integrations with the intensity after double integrations of a corresponding standard sample having a known concentration.

The ratio ($\Delta$Ti$^{3+}$/Ti$^{3+}$) of the variation in the Ti$^{3+}$ concentration to the average value of the Ti$^{3+}$ concentration in a TiO$_2$-SiO$_2$ glass is preferably 0.2 or less, more preferably 0.15 or less, still more preferably 0.1 or less, and particularly preferably 0.05 or less. When $\Delta$Ti$^{3+}$/Ti$^{3+}$ is 0.2 or less, coloration and distribution of characteristics, such as distribution of absorption coefficient, are reduced.

The $\Delta$Ti$^{3+}$/Ti$^{3+}$ is determined by the following method.

The Ti$^{3+}$ concentration is measured every 10 mm from end to end on an arbitrary line passing the center point of the sample surface. The difference between the maximum value and the minimum value of the Ti$^{3+}$ concentration is taken as $\Delta$Ti$^{3+}$ and divided by the average value of the Ti$^{3+}$ concentration to determine $\Delta$Ti$^{3+}$/Ti$^{3+}$.

(Thermal Expansion Coefficient)

In the silica-based glass substrate obtained by the production method of the present invention, the thermal expansion coefficient $C_{15-35}$ at 15 to 35°C is preferably in the range of $0\pm200$ ppb/°C. The silica-based glass substrate obtained by the production method of the present invention is used as a substrate for an imprint mold and therefore, is required to be excellent in dimensional stability against a temperature change, more specifically, excellent in dimensional stability against a temperature change in the temperature region capable of being experienced by the mold during imprint lithography. Here, the temperature region capable of being experienced by the imprint mold varies depending on the kind of imprint lithography. In the photo-imprint lithography, a photocurable resin is cured by ultraviolet irradiation and therefore, the temperature region capable of being experienced by the mold is fundamentally near room temperature. However, the temperature of the mold sometimes locally rises due to ultraviolet irradiation. Considering the local temperature rising due to ultraviolet irradiation, it is assumed that the temperature region capable of being experienced by the mold is 15 to 35°C. $C_{15-35}$ is more preferably in the range of $0\pm100$ ppb/°C, still more preferably in the range of $0\pm50$ ppb/°C, and particularly preferably in the range of $0\pm20$ ppb/°C.

In the silica-based glass substrate obtained by the production method of the present invention, the thermal expansion coefficient $C_{22}$ at 22°C is preferably $0\pm30$ ppb/°C, more preferably $0\pm10$ ppb/°C, and still more preferably $0\pm5$ ppb/°C. When $C_{22}$ is in the range of $0\pm30$ ppb/°C, the dimensional change due to temperature change can be neglected regardless of whether the value is positive or negative.

For achieving accurate measurement with a small number of measurement points like the thermal expansion coefficient at 22°C, the dimensional change of a sample due to temperature change by 1 to 3°C around the temperature is measured by using a laser heterodyne interferometric thermal expansion meter (for example, a laser heterodyne interferometric thermal expansion meter, CTE-01, manufactured by Uniopt), and the average thermal expansion coefficient determined is taken as the thermal expansion coefficient at the middle temperature.

(Internal Transmittance)

In the silica-based glass substrate obtained by the production method of the present invention, the internal transmittance $T_{300-700}$ per 1 mm of thickness in the wavelength region of 300 to 700 nm is preferably 70% or more, more preferably 80% or more, still more preferably 85% or more, and particularly preferably 90% or more.
In the photo-imprint lithography, a photocurable resin is cured by ultraviolet irradiation and therefore, the ultraviolet transmittance is preferably high.

In the silica-based glass substrate obtained by the production method of the present invention, the internal transmittance $T_{400-700}$ per 1 mm of thickness in the wavelength region of 400 to 700 nm is preferably 80% or more, more preferably 85% or more, and still more preferably 90% or more. When $T_{400-700}$ is 80% or more, visible light is hardly absorbed, as a result, the presence or absence of an internal defect such as bubble and stria is easily judged at the inspection with a microscope, an eye or the like, and a problem is less likely to occur in the inspection or evaluation.

In the silica-based glass substrate obtained by the production method of the present invention, the internal transmittance $T_{300-3000}$ per 1 mm of thickness in the wavelength region of 300 to 3,000 nm is preferably 70% or more, more preferably 80% or more, still more preferably 85% or more, and particularly preferably 90% or more. In the photo-imprint lithography, a photocurable resin is cured by ultraviolet irradiation and therefore, the ultraviolet transmittance is preferably high. Also, light absorption in the range of from visible light region to near infrared light region is suppressed, and a temperature rise due to light absorption is suppressed.

The internal transmittance is determined by the following method.
The transmittance of a sample (a mirror-polished glass substrate or a silica-based glass substrate obtained by etching the surface of the glass body above) is measured using a spectrophotometer. The internal transmittance per 1 mm of thickness is determined by measuring the transmittance on samples which are subject to polishing in the same level and different in the thickness, for example, a sample with a thickness of 2 mm and a sample with a thickness of 1 mm, converting each transmittance into an absorbance, subtracting the absorbance of the sample with a thickness of 1 mm from the absorbance of the sample with a thickness of 2 mm to obtain an absorbance per 1 mm of thickness, and again converting the absorbance into a transmittance.

(OH Concentration)

The OH concentration in the silica-based glass substrate obtained by the production method of the present invention is preferably less than 600 ppm by mass, more preferably 400 ppm by mass or less, still more preferably 200 ppm by mass or less, and particularly preferably 100 ppm by mass or less. When the OH concentration is less than 600 ppm by mass, reduction in the light transmittance in the near infrared region due to absorption by the OH group can be suppressed, and $T_{300-3000}$ hardly becomes less than 80%.

The OH concentration is determined by the following method.
Measurement is performed by means of an infrared spectrometer, and the OH concentration is determined from the absorption peak at a wavelength of 2.7 $\mu$m (J.P. Williams, et al., Ceramic Bulletin, 55(5), 524, 1976). The detection limit by this method is 0.1 ppm by mass.

(Fluorine Concentration)

The silica-based glass substrate obtained by the production method of the present invention may contain fluorine. In the case of incorporating F into the $TiO_2$-$SiO_2$ glass substrate for the purpose of widening the temperature range of zero expansion, the fluorine concentration is preferably 1,000 ppm by mass or more, more preferably 2,000 ppm by mass or more, still more preferably 3,000 ppm by mass or more, and particularly preferably 4,000 ppm by mass or more. In the case of the purpose of simply reducing the OH concentration, the fluorine concentration is preferably 100 ppm by mass or more, more preferably 200 ppm by mass or more, and still more preferably 500 ppm by mass or more.

(Halogen Concentration Other Than Fluorine)

In the silica-based glass substrate obtained by the production method of the present invention, the halogen concentration other than fluorine is preferably less than 50 ppm by mass, more preferably 20 ppm by mass or less, still more preferably 1 ppm by mass or less, and particularly preferably 0.1 ppm by mass or less. When the halogen concentration other than fluorine is less than 50 ppm by mass, the $Ti^{3+}$ concentration is hardly increased and therefore, brown coloration is less likely to occur. As a result, reduction in the transmittance is suppressed, and the transparency is hardly impaired.

The halogen concentration is determined by the following method.

The sample is heated and dissolved in a sodium hydroxide solution, and filtered through a cation removing filter. And then the resulting solution is quantitatively analyzed for the chlorine ion concentration by ion chromatograph analysis, whereby the chlorine concentration is determined.

The fluorine concentration is determined by a fluorine ion electrode method. Specifically, in accordance with the method disclosed in Journal of Chemical Society of Japan, 1972 (2), 350, the sample is heated and melted in anhydrous sodium carbonate, and to the obtained melt, distilled water and hydrochloric acid (in a volume ratio of 1:1) are added, whereby a sample solution is prepared. The electromotive force of the sample solution is measured by a radiometer by using No. 945-220 and No. 945-468, both are manufactured by Radiometer Trading, as a fluorine ion selective electrode and a comparative electrode, respectively, and the fluorine concentration is determined based on a calibration curve preliminarily created by using fluorine ion standard solutions.

Other halogen concentrations can be determined by a known method, for example, by ion chromatograph analysis.

<Imprint Mold>

In the present invention, the imprint mold is produced by forming a transfer pattern through etching on a surface of the silica-based glass substrate obtained by the production method of the present invention.

The transfer pattern is a reversed pattern of the target fine concave-convex pattern and consists of a plurality of fine convexes and/or concaves.

Examples of the convex include a long linear convex extending on the surface of the imprint mold, and protrusions scattered on the surface.

Examples of the concave include a long groove extending in the surface of the imprint mold, and holes scattered in the surface.

Examples of the shape of the linear convex or groove include a straight line, a curved line, and a bent line. A plurality of linear convexes or grooves may be present in parallel to make a stripe pattern.

Examples of the cross-sectional shape in the direction orthogonal to the longitudinal direction of the linear convex or groove include a rectangle, a trapezoid, a triangle, and a semicircle.

Examples of the shape of the protrusion or hole include a triangular prism, a quadrangular prism, a hexagonal prism, a circular cylinder, a triangular cone, a quadrangular cone, a hexagonal cone, a circular cone, a hemisphere, and a polyhedron.

The width of the linear convex or groove is, on average, preferably from 1 nm to 500 $\mu$m, more preferably from 10 nm to 100 $\mu$m, and still more preferably from 15 $\mu$m to 10 $\mu$m. The width of the linear convex means the length of the base in the cross-section in the direction orthogonal to the longitudinal direction. The width of the groove means the length of the top in the cross-section in the direction orthogonal to the longitudinal direction.

The width of the protrusion or hole is, on average, preferably from 1 nm to 500 $\mu$m, more preferably from 10 nm to 100 $\mu$m, and still more preferably from 15 nm to 10 $\mu$m. The width of the protrusion means, in the case of a long and thin bottom, the length of the base in the cross-section in the direction orthogonal to the longitudinal direction, and, otherwise, the maximum length in the bottom of the protrusion. The width of the hole means, in the case of a long and thin opening, the length of the top in the cross-section in the direction orthogonal to the longitudinal direction, and, otherwise, the maximum length in the opening of the hole.

The height of the convex is, on average, preferably from 1 nm to 500 $\mu$m, more preferably from 10 nm to 100 $\mu$m, and still more preferably from 15 nm to 10 $\mu$m.

The depth of the concave is, on average, preferably from 1 nm to 500 $\mu$m, more preferably from 10 nm to 100 $\mu$m, and still more preferably from 15 nm to 10 $\mu$m.

In the region where the transfer pattern is densely formed, the distance between adjacent convexes (or concaves) is, on average, preferably from 1 nm to 500 $\mu$m, and more preferably from 1 $\mu$m to 50 $\mu$m. The distance between adjacent convexes means the distance from the end of the base in the cross-section of a convex to the beginning of the base in the cross-section of the adjacent convex. The distance between adjacent concaves means the distance from the end of the top in the cross-section of a convex to the beginning of the top in the cross-section of the adjacent concave.

The minimum dimension of the convex is preferably from 1 nm to 50 $\mu$m, more preferably from 1 nm to 500 nm, and still more preferably from 1 nm to 50 nm. The minimum dimension means the minimum dimension out of the width, the length and the height of the convex.

The minimum dimension of the concave is preferably from 1 nm to 50 $\mu$m, more preferably from 1 nm to 500 nm, and still more preferably from 1 nm to 50 nm. The minimum dimension means the minimum dimension out of the width, the length and the depth of the concave.

<Method for Producing Imprint Mold>

The method for producing an imprint mold of the present invention is a method of forming a transfer pattern through etching on a surface of the silica-based glass substrate obtained by the production method of the present invention.

The etching method is preferably dry etching, and specifically, reactive ion etching with $SF_6$ is preferred.

(Function and Effect)

In the above-described method for producing an imprint mold of the present invention, since a transfer pattern is formed by etching on a surface of the silica-based glass substrate obtained by the production method of the present invention, an imprint mold having a transfer pattern with high dimensional accuracy is obtained.

Examples

The present invention is described in greater detail below by referring to Examples, but the present invention is not limited thereto.

Examples 1 to 3 are Production Examples, Examples 4 to 6 and 9 are Inventive Examples, and Examples 7 and 8 are Comparative Examples.

[Example 1]

(Step (a))

A $TiO_2$-$SiO_2$ glass fine particle obtained by mixing $TiCl_4$ and $SiCl_4$ as glass-forming raw materials each after gasification, and heating and hydrolyzing (flame-hydrolyzing) the mixed gas in oxyhydrogen flame was deposited and grown on a substrate for deposition to form a porous $TiO_2$-$SiO_2$ glass body.

The obtained porous $TiO_2$-$SiO_2$ glass body was difficult to handle without any treatment, and therefore, the glass body was held at 1,200°C for 4 hours in the air in the state of being still deposited on the substrate for deposition and then removed from the substrate for deposition.

(Step (b))

Thereafter, the porous $TiO_2$-$SiO_2$ glass body was held at 1,450°C for 4 hours under reduced pressure to obtain a $TiO_2$-$SiO_2$ dense body.

(Step (c))

The obtained $TiO_2$-$SiO_2$ dense body was put in a carbon mold and held at 1,680°C for 4 hours in an argon atmosphere under atmospheric pressure to obtain a transparent $TiO_2$-$SiO_2$ glass body.

(Step (d))

The obtained transparent $TiO_2$-$SiO_2$ glass body was put in a carbon mold and held at 1,700°C for 4 hours in an argon atmosphere under atmospheric pressure, thereby performing molding, to obtain a molded $TiO_2$-$SiO_2$ glass body.

(Steps (d') to (e))

The obtained molded $TiO_2$-$SiO_2$ glass body was held at 1,590°C for 120 hours in an argon atmosphere under atmospheric pressure (step (d')).

Subsequently, the glass body was cooled to 1,000°C at 10°C/hr, held at 1,000°C for 3 hours, cooled to 950°C at 10°C/hr, held at 950°C for 72 hours, cooled to 900°C at 5°C/hr, held at 900°C for 72 hours, and cooled to room temperature to

obtain a $TiO_2$-$SiO_2$ glass body (step (e)). The average cooling rate from 1,100°C to 700°C in the step (e) was 2.3°C/hr.

[Example 2]

(Step (a))

A $TiO_2$-$SiO_2$ glass fine particle obtained by mixing $TiCl_4$ and $SiCl_4$ as glass-forming raw materials each after gasification, and heating and hydrolyzing (flame hydrolyzing) the mixed gas in oxyhydrogen flame was deposited and grown on a substrate for deposition to form a porous $TiO_2$-$SiO_2$ glass body.
The obtained porous $TiO_2$-$SiO_2$ glass body was difficult to handle without any treatment, and therefore, the glass body was held at 1,200°C for 4 hours in the air in the state of being still deposited on the substrate for deposition and then removed from the substrate for deposition.

(Step (b))

Thereafter, the porous $TiO_2$-$SiO_2$ glass body was supported on a PFA (perfluoroalkoxyalkane)-made jig and together with the jig, put in a nickel-made autoclave (A/C). Subsequently, an NaF pellet (produced by Stella Chemifa Corporation) was inserted into the autoclave while keeping the pellet from contacting with the porous $TiO_2$-$SiO_2$ glass body, and the autoclave was externally heated by using an oil bath to heat to a temperature of 80°C.
While keeping the inside of the autoclave at 80°C, vacuum deaeration was performed until the pressure in the autoclave reached an absolute pressure of 266 Pa or lower, and the system was held for one hour.
Furthermore, a gas of elemental fluorine ($F_2$) diluted with a nitrogen gas to 20 vol% was introduced until the pressure in the apparatus reached a gauge pressure of 0.18 MPa, and after heating to 80°C, the system was held for 24 hours, whereby fluorine was introduced into the porous $TiO_2$-$SiO_2$ glass body. The glass body was then held at 1,450°C for 4 hours under reduced pressure to obtain a $TiO_2$-$SiO_2$ dense body.

(Step (c))

The obtained $TiO_2$-$SiO_2$ dense body was put in a carbon mold and held at 1,680°C for 4 hours in an argon atmosphere under atmospheric pressure to obtain a transparent $TiO_2$-$SiO_2$ glass body.

(Step (d))

The obtained transparent $TiO_2$-$SiO_2$ glass body was put in a carbon mold and held at 1,700°C for 4 hours in an argon atmosphere under atmospheric pressure, thereby performing molding to obtain a molded $TiO_2$-$SiO_2$ glass body.

(Step (e))

The obtained molded $TiO_2$-$SiO_2$ glass body was heated at 1,200°C, then cooled from 1,200°C to 500°C at 5°C/hr in the air and thereafter, allowed to stand to be cooled to room temperature to obtain a $TiO_2$-$SiO_2$ glass body.

[Example 3]

ULE#7972 produced by Coming Incorporated, which is known as a zero expansion $TiO_2$-$SiO_2$ glass, was held at 900°C for 100 hours in the air and then quenched to control the fictive temperature.

[Evaluation]

With respect to the $TiO_2$-$SiO_2$ glass body obtained in each of Examples 1 to 3, $TiO_2$ concentration, $Ti^{3+}$ concentration, $\Delta Ti^{3+}/Ti^{3+}$, OH concentration, halogen concentration, internal transmittance, fictive temperature, stress, and thermal expansion coefficient were determined by the methods described above. The results are shown in Table 1 and Table 2. Incidentally, the fictive temperature is not the distribution but the value of the entire glass body. Also, the data for the glass body in the section of [Evaluation] are not changed by the later-described cutting, shaving, polishing and etching treatments in the section of [Examples 4 to 9].

[Table 1]

| Example | TiO$_2$ Concentration [mass%] | Ti$^{3+}$ Concentration [wt ppm] | $\Delta$Ti$^{3+}$/Ti$^{3+}$ | OH Concentration [wt ppm] | Halogen Concentration [wt ppm] | T$_{400-700}$ [%] | T$_{300-700}$ [%] | T$_{300-3000}$ [%] |
|---|---|---|---|---|---|---|---|---|
| 1 | 6.7 | 2 | <0.05 | 40 | <1 | >97.4 | >91.6 | >90.9 |
| 2 | 5.9 | 12 | 0.09 | <10 | 3800 | >93.1 | >82.5 | >82.5 |
| 3 | 7.2 | 1 | <0.05 | 880 | <1 | >95.9 | >89.6 | >12.5 |

[Table 2]

| Example | Fictive Temperature [°C] | dev[σ] [MPa] | Δσ [MPa] | Thermal Expansion Coefficient $C_{15-35}$ at 15 to 35°C [ppb/°C] | Thermal Expansion Coefficient $C_{22}$ at 22°C [ppb/°C] |
|---|---|---|---|---|---|
| 1 | 960 | 0.03 | 0.14 | -13 to 22 | 1 |
| 2 | 900 | 0.06 | 0.30 | -7 to 15 | 3 |
| 3 | 900 | 0.05 | 0.25 | 35 to 95 | 48 |

[Examples 4 to 6]

The TiO$_2$-SiO$_2$ glass body obtained in each of Examples 1 to 3 is cut into a plate shape of length of about 153.0 mm x width of about 153.0 mm × thickness of about 6.75 mm by using an inner-diameter saw slicer and then chamfered to obtain a plate material of length of about 153.0 mm × width of about 153.0 mm × thickness of about 6.7 mm. Thereafter, using 20B double-side lapper (manufactured by SPEEDFAM Co., Ltd.), the main surface (surface on which a transfer pattern is to be formed) of the plate material is shaved with a slurry obtained by suspending from 18 to 20 mass% of an abrasive substantially composed of Al$_2$O$_3$ (AZ #1000 manufactured by HEISEI SANKEI Co., Ltd.) in filtrated water, until the thickness becomes about 6.5 mm. Then, the end face is mirror-processed.

Subsequently, as a first polishing step, the main surface of the plate material is polished about 50 μm by using the 20B double-side polisher with a foamed polyurethane-made polishing pad and an abrasive containing cerium oxide as a main component.

Furthermore, as a second polishing step, the main surface of the plate material is polished about 15 μm by using a 24B double-side polisher with a suede-based polishing pad in which an NAP layer is formed on nonwoven fabric bonded by polyurethane and which is a polishing pad coming under 68 in ASKER C in accordance with the Society of Rubber Industry, Japan Standard (SRIS), and an abrasive containing cerium oxide as a main component.

In addition, a third polishing step is performed by a different polishing machine. In this third polishing step, a suede-based polishing pad in which an NAP layer is formed on a PET sheet, and colloidal silica are used.

The obtained TiO$_2$-SiO$_2$ glass substrate is immersed in a 10 mass% hydrofluoric acid solution for 30 seconds, and the surface is thereby etched to obtain a TiO$_2$-SiO$_2$ glass substrate. The depth of etching can be calculated from the mass decrease and is 0.8 μm. This TiO$_2$-SiO$_2$ glass substrate is measured by the method above for fictive temperature distribution in the region from the surface to a depth of 10 μm on the side to be subjected to a transfer pattern formation, as a result, only a difference within 10°C is observed, which is a measurement error in the method of performing measurement by means of an infrared reflection spectrum.

[Example 7]

The TiO$_2$-SiO$_2$ glass body obtained in Example 1 is subjected to the same polishing as the polishing in the section of [Examples 4 to 6]. Without performing immersion in a 10 mass% hydrofluoric acid solution, the polished TiO$_2$-SiO$_2$ glass substrate is measured by the method above for fictive temperature distribution in the region from the surface to a depth of 10 μm on the side to be subjected to a transfer pattern formation, as a result, the fictive temperature on the outermost surface is higher by 70°C than the inside.

[Example 8]

The TiO$_2$-SiO$_2$ glass body obtained in Example 1 is subjected to the same polishing as the polishing in the section of [Examples 4 to 6], and then, the shape is corrected by a gas cluster ion beam. Thereafter, the main surface is again finished with a suedebased polishing pad in which an NAP layer is formed on a PET sheet, and colloidal silica. This TiO$_2$-SiO$_2$ glass substrate is measured by the method above for fictive temperature distribution in the region from the surface to a depth of 10 μm on the side to be subjected to a transfer pattern formation, as a result, the fictive temperature on the outermost surface is higher by 350°C than the inside.

[Example 9]

The TiO$_2$-SiO$_2$ glass substrate obtained in Example 8 is immersed in a 10 mass% hydrofluoric acid solution for one minute to etch the surface, to thereby obtain a TiO$_2$-SiO$_2$ glass substrate. The depth of etching can be calculated from the mass decrease and is 1.4 $\mu$m. This TiO$_2$-SiO$_2$ glass substrate is measured by the method above for fictive temperature distribution in the region from the surface to a depth of 10 $\mu$m on the side to be subjected to a transfer pattern formation, as a result, only a difference within 10°C is observed, which is a measurement error in the method of performing measurement by means of an infrared reflection spectrum.

[Conclusion]

In the TiO$_2$-SiO$_2$ glass substrate after the etching treatment of each of Examples 7 and 8, the fictive temperature distribution in the region from the surface to a depth of 10 $\mu$m on the side to be subjected to a transfer pattern formation is large and therefore, at the time of forming a transfer pattern (concave-convex pattern) by etching, a variation occurs in etching rate. As a result, dimensional accuracy of the transfer pattern is reduced.

In the TiO$_2$-SiO$_2$ glass substrate of each of Examples 4 to 6 and 9, the fictive temperature distribution in the region from the surface to a depth of 10 $\mu$m on the side to be subjected to a transfer pattern formation is small and therefore, at the time of forming a transfer pattern (concave-convex pattern) by etching, a variation hardly occurs in etching rate. As a result, dimensional accuracy of the transfer pattern is increased.

Incidentally, in the TiO$_2$-SiO$_2$ glass substrate of Example 6, since the OH concentration is high, $T_{300-3000}$ is small, and there is a possibility that light absorption may arise as a problem in use for photo-imprint lithography.

While the present invention has been described in detail and with reference to specific embodiments thereof, it will be apparent to one skilled in the art that various changes and modifications can be made therein without departing from the spirit and scope of the present invention.

This application is based on Japanese Patent Application No. 2009-276314 filed on December 4, 2009, the contents of which are incorporated herein by way of reference.

Industrial Applicability

The silica-based glass substrate obtained by the production method of the present invention is useful as a material for an imprint mold that is used for the purpose of forming a fine concave-convex pattern with a dimension of 1 nm to 10 $\mu$m in a semiconductor device, an optical waveguide, a micro-optical element (such as diffraction grating), a biochip, a microreactor, or the like.

**Claims**

1. A method for producing a silica glass substrate for an imprint mold, comprising: obtaining a glass body from a glass-forming raw material containing an SiO$_2$ precursor; machining said glass body into a glass substrate having a predetermined shape; and removing an affected layer on a surface of said glass substrate, to produce a silica glass substrate for an imprint mold having a fictive temperature distribution in a region from the surface to a depth of 10 $\mu$m on the side to be subjected to a transfer pattern formation of said glass substrate being within $\pm$30°C.

2. The method for producing a silica glass substrate for an imprint mold according to claim 1, wherein the removal of said affected layer is performed by an etching treatment.

3. The method for producing a silica glass substrate for an imprint mold according to claim 2, wherein said glass substrate surface is subjected to the etching treatment to remove a region from the surface to a depth of 100 nm or more of said glass substrate.

4. The method for producing a silica glass substrate for an imprint mold according to any one of claims 1 to 3, wherein said glass body is obtained by a process comprising the following steps (a) to (e):

   (a) a step of depositing a glass fine particle obtained from the glass-forming raw material containing an SiO$_2$ precursor by a soot process to obtain a porous glass body,
   (b) a step of heating said porous glass body to a densification temperature to obtain a dense body,
   (c) a step of heating said dense body to a transparent vitrification temperature to obtain a transparent glass body,
   (d) a step of, if desired, heating said transparent glass body to a softening point or higher and molding to obtain a molded glass body, and
   (e) a step of annealing the transparent glass body obtained in said step (c) or the molded glass body obtained in said step (d).

5. The method for producing a silica glass substrate for an imprint mold according to any one of claims 1 to 4, wherein said glass-forming raw material further contains a $TiO_2$ precursor.

6. The method for producing a silica glass substrate for an imprint mold according to claim 2 or 3, wherein said etching treatment contains a process of immersion in a fluorine-containing chemical solution.

7. A method for producing an imprint mold, comprising forming a transfer pattern through etching on a surface of the silica glass substrate for an imprint mold obtained by the production method according to any one of claims 1 to 6.

| **INTERNATIONAL SEARCH REPORT** | International application No. |
|---|---|
| | PCT/JP2010/071377 |

A.  CLASSIFICATION OF SUBJECT MATTER
*C03C15/00*(2006.01)i, *B29C33/38*(2006.01)i, *B29C59/02*(2006.01)i, *C03B8/04*(2006.01)i, *C03B20/00*(2006.01)i, *C03C3/06*(2006.01)i, *H01L21/027*(2006.01)i

According to International Patent Classification (IPC) or to both national classification and IPC

B.  FIELDS SEARCHED

Minimum documentation searched (classification system followed by classification symbols)
C03C15/00

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | WO 2009/034954 A1  (Asahi Glass Co., Ltd.), 19 March 2009 (19.03.2009), paragraphs [0001], [0020], [0023], [0030] to [0033], [0040] <br> & US 2010/0234205 A     & EP 2199049 A1 <br> & KR 10-2010-0058540 A | 1-7 |

☐  Further documents are listed in the continuation of Box C.        ☐  See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 16 December, 2010 (16.12.10) | 28 December, 2010 (28.12.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006306674 A
- WO 2009034954 A
- JP 63024937 B
- JP 2009276314 A

**Non-patent literature cited in the description**

- **J.P. WILLIAMS et al.** Ceramic Bulletin. 1976, vol. 55, 524
- *Journal of Chemical Society of Japan,* 1972, 350